# EUROPEAN PATENT APPLICATION

(11) **EP 4 745 830 A1**
(43) Date of publication of application: **20.05.2026**
(21) Application number: 24213418.7
(22) Date of filing: 15.11.2024
(51) Int. Cl.: G06F 30/33, G06F 30/367, G06F 30/398

(54) **SIGNAL PATH TRACING IN A DESIGN OF AN INTEGRATED CIRCUIT**

(71) Applicant: Luceda NV, 9000 Gent (BE)
(72) Inventor: Van Vrekhem, Dennis, 9520 Sint-Lievens-Houtem (BE); Fiers, Martin André Agnes, 9720 Laarne (BE); Chabert, François Daniel Raymond, 9200 Dendermonde (BE)
(74) Representative: Ipsilon Belgium

(57) **Abstract**

A computer-implemented method for determining a distribution of one or more properties of a light wave of an optical signal (2) propagating in a design (1) of an IC, comprising:
- receiving a design (1) comprising:
∘ a plurality of devices (100) comprising device ports (10);
∘ one or more nets (200) coupling two ports (10);

- for each of the devices (100), receiving a device scattering matrix (50);
- receiving a design scattering matrix (40) for the design (1);
- selecting one port (10) through which the optical signal (2) enters the design (1); and
- determining, in function of the nets (200) and the design scattering matrix (40) and each of the device scattering matrices (50), a distribution of properties of the optical signal (2) for each of the nets (200) along which the optical signal (2) propagates.

## Description

### Technical Field

The present invention generally relates, amongst others, to a computer-implemented method and a system for electronic design automation, also referred to as EDA. More particularly, it relates to a computer-implemented method and a system for operating on and/or editing a computer-implemented design of an integrated circuit, preferably within the framework of software for the design of photonic integrated circuits.

### Background

Electronic design automation, EDA, also referred to as electronic computer-aided design or ECAD, refers to a category of software tools or computer-implemented tools for designing electronic systems such as for example integrated circuits, also referred to as ICs, and/or printed circuit boards, also referred to as PCBs. A design of an IC typically comprises one or more devices, such as for example one or more electronic devices and/or one or more photonic devices. Each device is typically characterized by one or more ports through which the device may for example communicate with other devices of the design and/or for example may receive and/or transmit signals and/or at least partially isolate the device.

A workflow of a designer of for example a photonic IC usually comprises the following steps. The designer starts encoding the circuit layout of the devices of the IC, for example in Python or in any other suitable programming language. The circuit layout is to be understood as comprising a topology of the IC. A schematic is for example an abstract representation of the circuit layout of a photonic IC. Schematic Driven Layout, also referred to as SDL, can be used to generate a physical layout of an IC from one or more schematics. A schematic of the photonic IC is then the 'master' and the physical layout is implemented based on the schematic by adding placement of the devices and routing information between the devices. The designer can for example bring information from the layout into the schematic by using back annotations for verification. On the other hand, Layout Versus Schematic, also referred to as LVS, is the class of electronic design automation verification software that determines whether a particular physical layout of an IC corresponds to the original schematic or circuit diagram of the design. LVS can for example be used to generate a schematic of the IC by extracting the schematic from the physical layout.

Circuit simulations may also be ran by a designer to verify a functionality of each device and the whole functionality of the design. In the electronics domain, net tracing allows to graphically display end to end connections between devices comprised in a design of an IC or PCB. In the optical domain, circuit simulations can be ran to determine one or more parameters of an optical signal propagating for example from a port of a device or entering another device at another port. The results of the circuit simulations may be used to improve the generated schematics of the layout. Once the design complies with the requirements of the designer, a final layout is generated for production of the physical layout of the IC in for example a foundry.

### Summary

In the optical domain, it remains challenging to determine how an optical signal propagates through a design comprising a plurality of devices. In other words, it remains challenging to determine or simulate how light would physically propagate in a design of a photonic IC, especially in a complex circuit, if the photonic IC were to be physically manufactured.

It is thus an object of embodiments of the present invention to propose a computer-implemented method and a system which do not show the inherent shortcomings of the prior art. More specifically, it is an object of embodiments of the present invention to propose a computer-implemented method and a system to determine or simulate how an optical signal propagates in a design of a photonic IC, and how one or more properties of the optical signal are distributed during the propagation of the optical signal in the design.

The scope of protection sought for various embodiments of the invention is set out by the independent claims.

The embodiments and features described in this specification that do not fall within the scope of the independent claims, if any, are to be interpreted as examples useful for understanding various embodiments of the invention.

There is a need for a computer-implemented method which gives more insight to a designer of for example a photonic IC on how light would be travelling in a design of a photonic IC, and how one or more properties of the light would be distributed during its propagation in the design, if the photonic IC were to be manufactured. This way, if the design is finalized, a designer of the photonic IC can anticipate how light will travel through the design once the photonic IC is manufactured, and how one or more properties of the light will spread once the photonic IC is physically manufactured.

Amongst others, it is an object of embodiments of the invention to enable a computer-implemented method to determine how one or more properties of a light wave of an optical signal propagating or flowing or traveling between any two ports of a design of a photonic IC are distributed along one or more optical paths which can be followed by the light wave.

Amongst others, it is an object of embodiments of the invention to enable a computer-implemented method to graphically display how light would propagate or flow or travel between any two ports of a design of a photonic IC if the photonic IC were to be manufactured, and how one or more properties of the light wave of the optical signal would be distributed along the optical paths along which light could propagate.

This object is achieved, according to a first example aspect of the present disclosure, by a computer-implemented method for determining a distribution of one or more properties of a light wave of an optical signal propagating in a design of an integrated circuit, the method comprising the steps of:
- receiving a design of an integrated circuit comprising:
   ∘ a plurality of devices, each of the devices comprising ports; and
   ∘ one or more nets, each net coupling one of the ports of one of the devices to one of the ports of another one of the devices;
- for each of the devices, receiving a device scattering matrix;
- receiving a design scattering matrix for the design, wherein the design scattering matrix comprises:
   ∘ information comprised in the device scattering matrices; and
   ∘ information indicating one or more properties of the light wave of the optical signal propagating between any pair of ports of the ports of the design, wherein any one of the ports of the pair of ports can be coupled to another one of the ports of the design through one of the nets;
- selecting one of the ports of one of the devices through which the optical signal enters the design; and
- determining, in function of the nets and in function of the design scattering matrix, a distribution of one or more properties of the light wave of the optical signal for each of the ports along which the optical signal propagates starting from the selected port.

With the computer-implemented method according to the present disclosure, it becomes possible to determine how a light wave of an optical signal propagates from a selected port in a design of an integrated circuit and to further determine a distribution or evolution or spread of one or more properties of the light wave of the optical signal within the design. In other words, it becomes possible to determine a distribution of one or more properties of the light wave of the optical signal along one or more possible optical routes which can be followed by the light wave of the optical signal between the selected port and any other port in the design. This way, the computer-implemented method according to the present disclosure permits the determination and the anticipation of an evolution of the values of one or more properties of the light wave along optical paths which could be followed by light starting from the selected port of the integrated circuit if the design of the integrated circuit were to be manufactured. In other words, the computer-implemented method according to the present disclosure permits the determination or the simulation of variations of the values of one or more properties of the light wave along routes which could be followed by light starting from the selected port of the integrated circuit if the design of the integrated circuit were to be manufactured. As will be described in further details below, establishing in an accurate manner how light is going to travel in a design and quantifying how properties of the light are going to vary in a physical layout is very valuable information for a designer or a user of a design, especially for somewhat more complex integrated circuits comprising for example tens or hundreds or thousands devices, and of course depending on potential processing variations. The variation of the properties may for example be rendered to be graphically displayed. This provides visual information to a designer and/or a user of the design on a distribution of the properties of light in the integrated circuit once the integrated circuit is manufactured in an intuitive and simple manner. For example, it allows the designer and/or the user of the design to verify and/or debug a design before relying on the design for the generation of a physical layout of the IC.

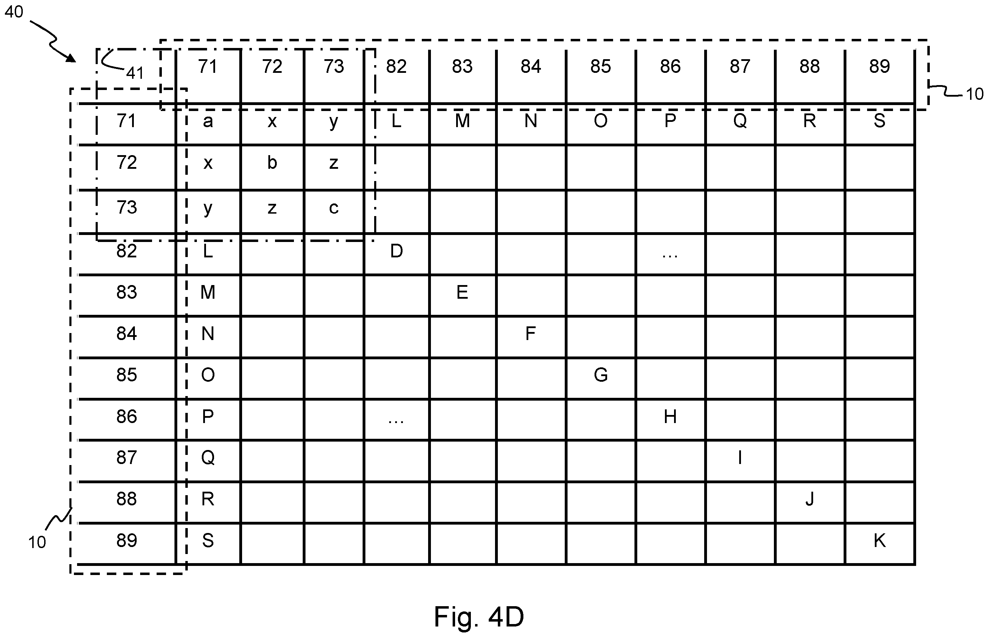

The computer-implemented method according to the present disclosure relies on the use of a design scattering matrix for the design, wherein the design scattering matrix comprises all the device scattering matrices of the devices comprised in the design, and further comprises information on the connectivity between the devices and properties of the light wave propagating between any two ports of the devices of the design. In other words, the design scattering matrix used by the computer-implemented method according to the present disclosure for the design does not only provide information on the ports of devices positioned at the outer edges of the design, i.e. the outermost ports of the design at outermost positions in the design and through which an optical signal can enter and/or leave the design. On the contrary, the design scattering matrix used by the computer-implemented method according to the present disclosure is a co-called exploded scattering matrix in which all the ports of all the devices of the design are exposed to the computer-implemented method according to the present disclosure for processing, for example wherein the computer-implemented method according to the present disclosure has access to all the ports of all the devices of the design and can take them one or more or even all of them into account when determining the distribution of one or more properties of the light wave of the optical signal propagating in the design. An example of a design scattering matrix is depicted and described on Fig. 4D. The design scattering matrix used by the computer-implemented method according to the present disclosure further comprises information on the connectivity between the ports of the devices of the design. The design scattering matrix used by the computer-implemented method according to the present disclosure comprises information indicating one or more properties of the light wave of the optical signal propagating between two ports of the design, wherein any one of these two ports can be coupled to another one of the ports of the design through one of the nets of the design.

The computer-implemented method according to the present disclosure relies on a definition of a device scatting matrix for each of the devices of the design of the integrated circuit. This involves the automatic extraction of each scattering parameter, also referred to as S-parameter, for each device in the design. In the context of the present disclosure, a scattering parameter refers to an element in a mathematical matrix describing the behavior of a photonic device or network or circuit when it is being stimulated by an optical signal. With the computer-implemented method according to the present disclosure, a device scattering matrix is determined for each of the devices of the design. In other words, the computer-implemented method according to the present disclosure derives variations of properties of the light wave between devices. This definition can be done manually by a designer or a user of the design. Alternatively, this definition can be automated based on the S-parameters of each device. The computer-implemented method according to the present disclosure does not derive variations of properties of the light wave within each of the devices of the design, only between two devices along which the optical signal propagates. In other words, the computer-implemented method according to the present disclosure does not determine how the light wave is distributed within a device. It only determines how the light wave is distributed from port to port.

The computer-implemented method according to the present disclosure further relies on a definition of a design scattering matrix for the entire design of the integrated circuit comprising all the devices. This involves the automatic extraction of a scattering parameter, also referred to as S-parameter, for the whole design. In the context of the present disclosure, a scattering parameter refers to an element in a mathematical matrix describing the behavior of an photonic device or network or circuit or design when it is being stimulated by a light wave of an optical signal. With the computer-implemented method according to the present disclosure, a design scattering matrix is determined for the design. The design scattering matrix comprises information comprised in the device scattering matrices and information on the nets. The computer-implemented method according to the present disclosure further involves the extraction of one or more properties of the light wave taking into account the design scattering matrix comprising the device scattering matrices and information on the connectivity between the devices through the nets. In other words, the computer-implemented method according to the present disclosure derives variations of properties of the light wave between devices and within the entire design. This definition can be done manually by a designer or a user of the design. Alternatively, this definition can be automated based on the S-parameters of the design.

The computer-implemented method according to the present disclosure is useful in for example debugging a design. The designer or a user of the design can identify and intuitively understand how one or more properties of a light wave propagating to another port starting from the selected port are distributed, and the designer or a user of the design can easily recognize expected or unexpected obstacles and/or presence of parasitics and/or attenuation for the light wave optical signal, and/or expected or unexpected leakage of the light wave of the optical signal. This allows improving the design to meet the technical requirements for the IC better. Additionally, the computer-implemented method according to the present disclosure makes it possible to verify a design. For example, a designer or a user of a design initially expects a light wave of an optical signal to demonstrate a given amplitude or phase in the design. With the computer-implemented method according to the present disclosure, the designer or the user can identify leakage of the optical signal or attenuation or parasitics, wherein leakage to the other optical paths is non-desired. By improving the design, leakage of the optical signal may be minimized or even avoided, thereby greatly improving the quality and the reliability of the design. The design can for example be improved by for example selecting better suited devices for the design, changing the connectivity of the nets between the devices, optimizing the devices themselves, etc. The method according to the present disclosure is for example useful in that it helps quickly identifying crucial building blocks that require further design optimization so that for example leakage can be minimized or even avoided, etc. Additionally, with the method according to the present disclosure, it becomes possible to determine more accurately how one or more properties of the light wave of the optical signal are distributed along the optical path followed by the optical signal, taking into account parasitics that may accumulate in the design. For example, it becomes possible to identify resonances of the light wave within the design. Resonances will for example demonstrate a positive dB in the results of the simulation. In another example, a resonance could also be weak, and with a lot of loss, thereby not necessarily giving positive dB. With the computer-implemented method according to the present disclosure, such resonances can be identified.

With the computer-implemented invention according to the present disclosure, a property of the light wave propagating between a second port and a third port of the design is related to or characterized with respect to the same property of the same light wave propagating between a first port and the second port of the design, wherein the first port is closer in number of ports to the selected port than the second port. The property of the light wave propagating between the second port and the third port of the design is also related to or characterized with respect to the same property of the same light wave propagating between the third port and a fourth port of the design, wherein the third port is closer in number of ports to the selected port than the fourth port. This way, a relative evolution of the property of the light wave is determined and can be quantified. The distribution or evolution of the changes in the properties of the light wave can be displayed in such a way that it becomes possible to compare an amount of the property relatively between different sections of the design. For example, when an amplitude of the light wave decreases between two consecutive regions of the design, it may be graphically rendered by lowering the thickness of the displayed route followed by the light wave. For example, when an amplitude of the light wave increases between two consecutive regions of the design, it may be graphically rendered by increasing the thickness of the displayed route followed by the light wave. For example, when an amplitude of the light wave increases or decreases between two consecutive regions of the design, it may be graphically rendered by a gradient color or a color ramp for the displayed route followed by the light wave, one section displaying a brighter, respectively less intense, or darker, respectively lighter, color than the other section. For example, an amplitude of the light wave of the optical signal can be graphically rendered by being displayed by an arrow coupled to each of the ports of the devices of the design, wherein a surface of the arrow is indicative for an amplitude of the light wave and wherein an orientation of the arrow is indicative for a direction of propagation of the light wave. For example, when an amplitude of the light wave decreases within a device of the design, it may be graphically rendered by decreasing the surface of the arrow coupled to an output port of the corresponding device. For example, when an amplitude of the light wave increases within a device of the design, it may be graphically rendered by increasing the surface of the arrow coupled to an output port of the corresponding device. Reflections may also for example be displayed. In other words, two arrows may be coupled to one of the nets, wherein one arrow indicates that the light wave leaves a first device to enter a second device coupled to the first device via the net, and wherein another arrow indicates that a reflected light wave leaves the second device to enter the first device.

In the context of the present disclosure, the design of the integrated circuit may further comprise a direction of propagation for the light waves of optical signals within the design from the selected port. For example, by selecting one of the ports of one of the devices, the computer-implemented method according to the present disclosure defines a direction of propagation for the optical signals which start propagating at the selected port and which propagate towards any other port of the design depending upon the device scattering matrices and the design scattering matrix. The light waves of the optical signals may encounter one or more reflections and/or leakage and travel back in a direction opposite to the initial direction of propagation. Not all light waves might travel through the entire design when starting from the selected port and when propagating along the direction of propagation. The determination of one or more optical paths for a light wave of an optical signal from the selected port happens in function of the nets and the device scattering matrices of each of the devices and the design scattering matrix and according to the direction of propagation. It is clear that the propagation of at least a fraction of the light wave of the optical signal is bidirectional in the design, in other words, from the selected port to any other port of the device and from any port of the design to the selected port.

In the context of the present disclosure, each device comprises one or more ports, wherein the ports comprise one or more input ports and/or one or more output ports. Ports are locations on the layout of the design where connections between devices are made. Each port has a name and a location in the design. A port is for example an optical port for the connection of for example optical waveguides or fibers. Alternatively, a port is for example an electrical port for the connection with for example electrical wires. A pair of ports comprises two ports of the ports of the design. Each input port is configured to receive for example one or more optical signals, sequentially or substantially simultaneously, wherein the optical signals are later on referred to as received optical signals. Each output port is configured to transmit for example one or more optical signals, sequentially or substantially simultaneously, wherein the transmitted optical signals correspond to the received optical signals having being transmitted through or processed by or having experienced optical processing within the respective device. Additionally, an input port may act as an output port when for example the input port receives an optical signal, and wherein the device is for example a reflector. In this event, the input port of the device transmits the reflected optical signal back out of the device, thereby acting as an output port for the device. Similarly, an output port may act as an input port when for example the output port transmits an optical signal, and wherein the optical signal is transmitted to another device which for example comprises a reflector. In this event, the output port of the device receives the reflected optical signal back into the device, thereby acting as an input port for the device.

In the context of the present disclosure, any port of any device of the design may be selected as the selected port.

In the context of the present disclosure, an optical signal comprises one or more light waves. An optical signal comprises discrete units called photons. An optical signal is an electromagnetic signal. It comprises an electric field and a magnetic field that are orthogonal to each other. In other words, an optical signal comprises electromagnetic energy waves, or EM radiation. The EM spectrum includes RF, light, X-rays, and gamma rays. The optical signals in the EM spectrum comprise oscillating electric fields and magnetic fields that are orthogonal to one another, traveling in a particular direction.

In the context of the present disclosure, an optical path corresponds to an optical route passing through one or more devices of a design comprised between the two ports of a device or between two ports of two devices, wherein the optical route is followed by a light wave of an optical signal. In other words, an optical signal propagates or flows or follows a path from one device to another and through one or more devices along an optical path comprised between two ports.

In the context of the present disclosure, a device scattering matrix of a device comprises rows corresponding to all the input ports and all the output ports of the device, and further comprises columns corresponding to all the input ports and all the output ports of the device. A device scattering matrix uses a numerical system. A device scattering matrix of a device indicates if a light wave of an optical signal can propagate from any input port or output port of the device to any input port or output port of the same device and further indicates how much of the light wave can actually propagate from any input port or output port of the device to any input port or output port of the same device. In other words, a device scattering matrix indicates the transmission possibilities and characterizes the transmission of an optical signal between any two ports of the device.

In the context of the present disclosure, a design scattering matrix comprises rows corresponding to all the input ports and all the output ports of all the devices of the design, and further comprises columns corresponding to all the input ports and all the output ports of all the devices of the design. A design scattering matrix uses a numerical system. A design scattering matrix is complex-valued between 0 and 1. A design scattering matrix of a device indicates if a light wave of an optical signal can propagate from any input port or output port of any of the devices of the design to any input port or output port of any of the devices of the design and further indicates how much of the light wave can actually propagate from any input port or output port of any of the devices of the design to any input port or output port of the any of the devices of the design. In other words, a design scattering matrix indicates the transmission possibilities and characterizes the transmission of an optical signal between any two ports of the design.

In the context of the present disclosure, a net is a connection or a link between two devices. For example, a net can be a connection between two waveguides, while each waveguide is understood in the context of the present invention as a device.

In the context of the present invention, electronic design automation, also referred to as electronic computer-aided design or ECAD, refers to a category of software tools or computer-implemented tools for designing electronic systems such as for example integrated circuits and/or printed circuit boards. The tools work together in a design flow that chip designers use to design and analyse entire semiconductor chips. EDA tools focus for example on one or more of the following: the design of integrated circuits, simulations of the integrated circuits such as for example electrical simulations and/or electromagnetic simulations, analysis and verifications, manufacturing preparations, functional safety, etc. The term "automation" refers to the ability for end-users to augment, customize, and drive the capabilities of electronic and photonic design and verification tools by means of a scripting language and associated support utilities. The term "automation" further refers to the ability for end-users to automate tasks by means of computer algorithms instead of the user having to execute the same task by hand. The benefits are not only speed but most importantly reproducibility by removing human error. There are a wide variety of programming languages available for electronic design automation, such as for example traditional C and its object-oriented offspring, C++, Python, TCL, Cadence SKILL^{®}, SystemC, VHDL, verilog, Java, etc.

In the context of the present invention, an integrated circuit or monolithic integrated circuit, also referred to as an IC, a chip, or a microchip, is a set of electronic circuits and/or photonics circuits and/or microelectromechanical circuits and/or fluidic devices, on one small flat piece of semiconductor material that is for example silicon. The integration of large numbers of small electronic, photonic, MEMs components such as for example transistors and/or waveguides, into a small chip results in circuits that are orders of magnitude smaller, faster, and less expensive than those constructed of discrete components.

In the context of the present invention, a fluidic device corresponds to a device along which water may propagate.

A photonic integrated circuit or integrated optical circuit is a device that integrates multiple photonic functions and as such is similar to an electronic integrated circuit. A photonics device is any basic discrete device or physical entity in a photonics system used to affect photons or their associated fields. The major difference between the two is that a photonic integrated circuit provides functions for information signals imposed on optical wavelengths for example comprised in the visible spectrum or near infrared 850 nm-1650 nm. One example of material platform for photonic integrated circuits is indium phosphide, which allows for the integration of various optically active and passive functions on the same chip. Examples of photonic integrated circuits comprise two-section distributed Bragg reflector lasers, monolithic tunable lasers, widely tunable lasers, externally modulated lasers and transmitters, integrated receivers, etc. Alternatively, for example, silicon can, even though it is an indirect bandgap material, still be used to manufacture photonic integrated circuits.

In the context of the present disclosure, a scattering matrix of a device comprises rows corresponding to all the input ports and all the output ports of the device, and further comprises columns corresponding to all the input ports and all the output ports of the device. A scattering matrix uses a numerical system not only based on the numerals 0 and 1. A scattering matrix is complex-valued. A scattering matrix of a device indicates how much of an optical signal can propagate from any input port or output port of the device to any input port or output port of the same device. In other words, a scattering matrix indicates the transmission possibilities and quantifies the optical signal strength of the transmission of an optical signal between any two ports of the device.

The design scattering matrix is environment-dependent. Each device scattering matrix is environment-dependent. For example, the design scattering matrix is wavelength- and/or frequency- and/or temperature- dependent. For example, each device scattering matrix is wavelength- and/or frequency- and/or temperature-dependent. The environment can be understood as the wavelength, the frequency, the temperature, or any other suitable globally defined property such as for example processing tolerances.

According to example embodiments, the one or more properties comprise one or more of the following:
- an amplitude of the light wave of the optical signal;
- an intensity of the light wave of the optical signal;
- a phase of the light wave of the optical signal;
- one or more losses for the light wave of the optical signal;
- a dispersion of the light wave of the optical signal.

This way, it becomes possible to characterize an evolution or a variation of for example the amplitude of the light wave within the design. Attenuations, losses, parasitics can therefore be identified. Changes in phase can be determined and provide valuable information for example for applications such as beam steering.

According to example embodiments, the design scattering matrix for the design relates a property of the light wave of the optical signal entering the design through one of the ports of one of the devices to a property of the light wave of the optical signal leaving the design through one of the ports of one of the devices.

By combining information comprised in the device scattering matrix in the design scattering matrix with information on the connectivity between devices, it becomes possible to characterize one or more properties of the light wave between two ports of the design and to further characterize a distribution or evolution of the properties for each of the ports along which the optical signal propagates.

According to example embodiments, each device scattering matrix relates a property of the light wave of the optical signal entering the device through one of the device ports to a property of the light wave of the optical signal leaving the device through one of the device ports.

Using the information comprised in the device scattering matrices, it becomes possible to characterize one or more properties of the light wave between two ports of the same device and to further characterize a distribution or evolution of the properties between the two ports of the same device between which the optical signal propagates.

According to example embodiments, the design scattering matrix comprises information indicative for how much of the optical signal propagates from one of the ports to another one of the ports per wavelength or frequency comprised in the optical signal.

By combining information comprised in the device scattering matrices and connectivity between the devices in the design scattering matrix, it becomes possible to characterize one or more properties of the light wave between two ports of the design and to further quantify a distribution or evolution of the properties for each of the ports along which the optical signal propagates. These characterization and quantification are performed per value of an environment of the optical signal, comprising for example wavelength or frequency, temperature, processing parameter, etc.

According to example embodiments, each device scattering matrix of each device comprises information indicative for how much of the optical signal propagates from one of the device ports of the device to another one of the device ports of the device per wavelength or frequency comprised in the optical signal.

Using the information comprised in the device scattering matrices, it becomes possible to characterize one or more properties of the light wave between two ports of the same device and to further characterize a distribution or evolution of the properties between the two ports of the same device between which the optical signal propagates. These characterization and quantification are performed per wavelength or frequency comprised in the optical signal.

According to example embodiments, the design scattering matrix comprises information indicative for how much of the optical signal propagates from one of the ports to another one of the ports for each optical mode comprised in the optical signal.

By combining information comprised in the device scattering matrices and information on the connectivity between the devices in the design scattering matrix, it becomes possible to characterize one or more properties of the light wave between two ports of the design and to further quantify a distribution or evolution of the properties for each of the ports along which the optical signal propagates. These characterization and quantification are performed for each optical mode comprised in the optical signal.

According to example embodiments, each device scattering matrix of each device comprises information indicative for how much of the optical signal propagates from one of the device ports of the device to another one of the device ports of the device for each optical mode comprised in the optical signal.

Using the information comprised in the device scattering matrices, it becomes possible to characterize one or more properties of the light wave between two ports of the same device and to further characterize a distribution or evolution of the properties between the two ports of the same device between which the optical signal propagates. These characterization and quantification are performed for each optical mode comprised in the optical signal.

According to example embodiments, the method further comprises the steps of:
- determining a device scattering matrix for each device of a plurality of available devices comprising the devices of the design of the integrated circuit; and
- storing the device scattering matrices of the available devices in a database;
and wherein, upon receipt of the design of the integrated circuit, the step of receiving a device scattering matrix for each of the devices of the design of the integrated circuit corresponds to retrieving the device scattering matrices of the devices of the design of the integrated circuit from the database.

This way, all the device scattering matrices are determined beforehand and are available immediately upon request. The device scattering matrices may be stored in a database, such as for example a library, and are linked to the respective devices. Determining the device scattering matrices upfront allows to save processing power and processing time when a designer and/or a user of the design requests the determination of the distribution of one or more properties of the light wave. In other words, the time spent for calculating all the device scattering matrices is spent before the designer and/or the user requests the determination of the distribution of one or more properties of the light wave, thereby speeding the process of determining the evolution of the properties.

According to example embodiments, upon receipt of the design of the integrated circuit, the step of receiving a device scattering matrix for each of the devices of the design of the integrated circuit corresponds to determining a device scattering matrix for each of the devices of the design of the integrated circuit.

This way, a device scattering matrix may be determined on the spot by the method according to the present disclosure. For example, when a new device is added to the design, a new device scattering matrix must be determined for the device. This brings flexibility and improves the reactivity of the method to a more personalized design experience, thereby improving the user experience.

According to example embodiments, the method further comprises the steps of:
- generating a representation of the design of the integrated circuit incorporating the one or more optical paths and the distribution of one or more properties of the light wave of the optical signal for each of the nets along each of the optical paths and for each of the ports in the design; and
- displaying the representation of the design of the integrated circuit in a user client.

The representation of the design of the integrated circuit may be displayed to a browser. This way, graphically displaying the representation of the design in a user client remains independent from the nature and the version of the operating systems of different user clients, and independent from the applications and from the version of the applications running on for example application servers. For example, the representation of the design of the integrated circuit may be streamed to a user client in a browser, thereby keeping the implementation of the method according to the present disclosure lightweight. This simple and light implementation at the side of the user client minimizes the configuration of the user client. For example, the user client may comprise a Graphical User Interface. The generator of the representation of the design and the user client and the unit displaying the representation of the design are for example comprised in a system according to a second example aspect of the present invention.

In the context of the present disclosure, a user client may be a Command-Line Interface (CLI) Client, which is a text-based interface that allows users to interact with a system or service using commands. Examples include terminal emulators like Command Prompt on Windows, Terminal on macOS, and various Unix/Linux shells like Bash. Alternatively, a user client may be a Graphical User Interface (GUI) Client, which is software with graphical interfaces that allow users to interact with a system or service using menus, buttons, and other visual elements. Examples include FTP clients like FileZilla, database management tools like phpMyAdmin, and version control clients like GitHub Desktop. Alternatively, a user client is an API Client, which is software applications or libraries that allow developers to interact with an API (Application Programming Interface) to access and manipulate data or services. Examples include Postman for testing REST APIs and cURL for making HTTP requests from the command line.

According to a second example aspect of the present invention, there is provided a system for determining a distribution of one or more properties of a light wave of an optical signal propagating in a design of an integrated circuit, the method comprising the steps of:
- receiving a design of an integrated circuit comprising:
   ∘ a plurality of devices, each of the devices comprising ports; and
   ∘ one or more nets, each net coupling one of the ports of one of the devices to one of the ports of another one of the devices;
- for each of the devices, receiving a device scattering matrix;
- receiving a design scattering matrix for the design, wherein the design scattering matrix comprises:
   ∘ information comprised in the device scattering matrices; and
   ∘ information indicating one or more properties of the light wave of the optical signal propagating between any pair of ports of the ports of the design, wherein any one of the ports of the pair of ports can be coupled to another one of the ports of the design through one of the nets;
- selecting one of the ports of one of the devices through which the optical signal enters the design; and
- determining, in function of the nets and in function of the design scattering matrix, a distribution of one or more properties of the light wave of the optical signal for each of the ports along which the optical signal propagates starting from the selected port.

There is provided a system comprising:
- a processor;
- a memory;
- an optical paths determination module executable by the processor to:
   ∘ receive a design of an integrated circuit comprising:
      ▪ a plurality of devices, each of the devices comprising ports; and
      ▪ one or more nets, each net coupling one of the ports of one of the devices to one of the ports of another one of the devices;
   ∘ for each of the devices, receive a device scattering matrix;
   ∘ receive a design scattering matrix for the design, wherein the design scattering matrix comprises:
      ▪ information comprised in the device scattering matrices; and
      ▪ information indicating one or more properties of the light wave of the optical signal propagating between any pair of ports of the ports of the design, wherein any one of the ports of the pair of ports can be coupled to another one of the ports of the design through one of the nets;
   ∘ select one of the ports of one of the devices through which the optical signal enters the design; and
   ∘ determine, in function of the nets and in function of the design scattering matrix, a distribution of one or more properties of the light wave of the optical signal for each of the ports along which the optical signal propagates starting from the selected port.

The memory for example is for example configured to store the device scattering matrices of the devices.

According to example embodiments, each of the optical paths along which the light wave can propagate comprises one or more of the nets.

This way, an optical path comprises the devices and further comprises the connections or the links between the corresponding devices.

According to a third example aspect of the present invention, there is provided a computer program product comprising computer-executable instructions for causing a system to perform at least the following:
- receiving a design of an integrated circuit comprising:
   ∘ a plurality of devices, each of the devices comprising ports; and
   ∘ one or more nets, each net coupling one of the ports of one of the devices to one of the ports of another one of the devices;
- for each of the devices, receiving a device scattering matrix;
- receiving a design scattering matrix for the design, wherein the design scattering matrix comprises:
   ∘ information comprised in the device scattering matrices; and
   ∘ information indicating one or more properties of the light wave of the optical signal propagating between any pair of ports of the ports of the design, wherein any one of the ports of the pair of ports can be coupled to another one of the ports of the design through one of the nets;
- selecting one of the ports of one of the devices through which the optical signal enters the design; and
- determining, in function of the nets and in function of the design scattering matrix, a distribution of one or more properties of the light wave of the optical signal for each of the ports along which the optical signal propagates starting from the selected port.

According to a fourth example aspect of the present invention, there is provided a computer readable storage medium comprising computer-executable instructions for performing the following steps when the program is run on a computer:
- receiving a design of an integrated circuit comprising:
   ∘ a plurality of devices, each of the devices comprising ports; and
   ∘ one or more nets, each net coupling one of the ports of one of the devices to one of the ports of another one of the devices;
- for each of the devices, receiving a device scattering matrix;
- receiving a design scattering matrix for the design, wherein the design scattering matrix comprises;
   ∘ information comprised in the device scattering matrices; and
   ∘ information indicating one or more properties of the light wave of the optical signal propagating between any pair of ports of the ports of the design, wherein any one of the ports of the pair of ports can be coupled to another one of the ports of the design through one of the nets;
- selecting one of the ports of one of the devices through which the optical signal enters the design; and
- determining, in function of the nets and in function of the design scattering matrix, a distribution of one or more properties of the light wave of the optical signal for each of the ports along which the optical signal propagates starting from the selected port.

### Brief Description of the Drawings

Some example embodiments will now be described with reference to the accompanying drawings.
Fig. 1 depicts an example embodiment of a distribution of a property of a light wave of an optical signal, determined by an example embodiment of a method according to the present disclosure.
Fig. 2 depicts an example embodiment of a distribution of a property of a light wave of an optical signal, determined by an example embodiment of a method according to the present disclosure.
Fig. 3A depicts an example embodiment of a distribution of a property of a light wave of an optical signal, determined by an example embodiment of a method according to the present disclosure. Fig. 3B depicts an example embodiment of a distribution of a property of a light wave of an optical signal, determined by an example embodiment of a method according to the present disclosure.
Fig. 4A depicts an example embodiment of a directional coupler. Fig. 4B depicts an example embodiment of a device scattering matrix of a directional coupler according to the present disclosure. Fig. 4C depicts an example embodiment of a design according to the present disclosure. Fig. 4D depicts an example embodiment of a design device matrix of the design of Fig. 4C according to the present disclosure.
Fig. 5 shows an example embodiment of a suitable computing system for performing one or several steps in embodiments of the invention.

### Detailed Description of Embodiment(s)

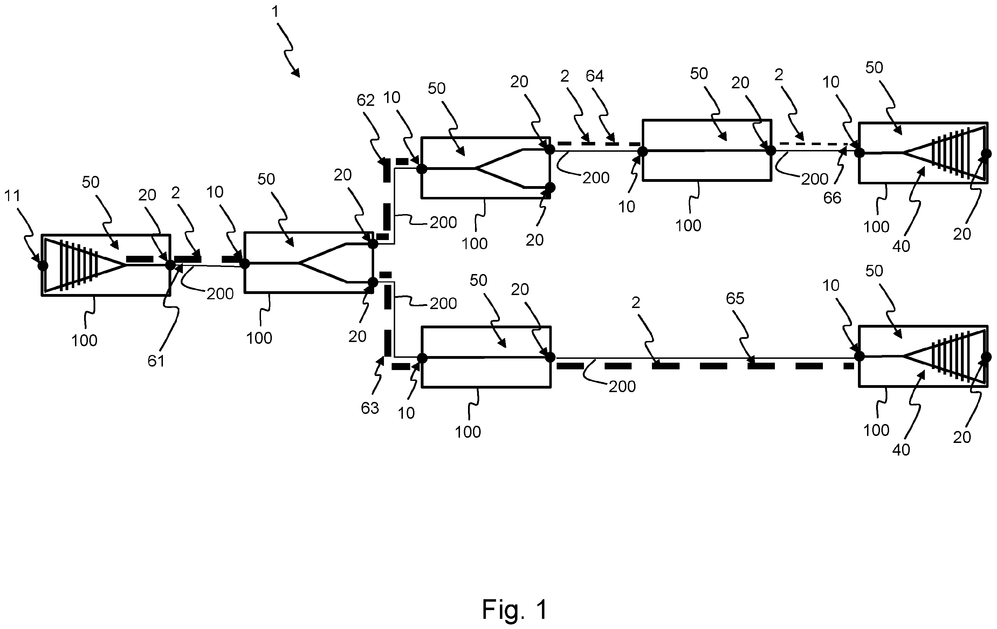

Fig. 1 illustrates an example embodiment of a distribution of a property of a light wave of an optical signal 2, determined by an example embodiment of a method according to the present disclosure. The method according to the present disclosure is used for determining a distribution of a property of the light wave in a design 1 of an integrated circuit. The method comprises the steps of receiving a design 1 of an integrated circuit, wherein the design 1 comprises seven devices 100, each of the devices 100 comprising ports 10;20. The devices 100 can be grating couplers, directional couplers, splitters, MMIs, AWGs, waveguides, reflectors, couplers, any other photonic device. The design 1 further comprises a plurality of nets 200, wherein each net 200 couples one of the ports 10 or 20 of one of the devices 100 to one of the ports 10 or 20 of another one of the devices 100. For each of the devices 100, a device scattering matrix 50 is received and indicates between which ports of the device 100 the light wave of the optical signal 2 can propagate within the device 100 and further indicates how much of the property of the lightwave is transmitted between ports within the device 100. One of the ports 10 of the design 1 has been selected as a selected port 11. The evolution of at least one property of the light wave of the optical signal 2 from the selected port 11 is determined in function of the device scattering matrices 50 of each of the devices encountered by the light wave propagating from the selected port 11. The light wave starts propagating from the selected port 11 along the section 61. A property of the light wave is for example an amplitude of the light wave. In section 61, the amplitude corresponds to an initial amplitude value. The light wave further propagates to another device 100 and to sections 62 and 63. The method determines that an amplitude of the light wave in sections 62 and 63 is substantially identical to an amplitude of the light wave in section 61. This is visible in the graphical rendering on Fig. 1, wherein a thickness of representation of the light wave in sections 62 and 63 is identical to the thickness of representation of the light wave in section 61. After section 63, the light wave keeps propagating through other devices and through section 65. The method determines that an amplitude of the light wave in section 65 substantially identical to an amplitude of the light wave in section 63. This is visible in the graphical rendering on Fig. 1, wherein a thickness of representation of the light wave in section 65 is identical to the thickness of representation of the light wave in section 63. On the other hand, after section 62, the light wave keeps propagating through other devices and through sections 64 and 66. The method determines that an amplitude of the light wave in section 64 is substantially lower to an amplitude of the light wave in section 62. This is visible in the graphical rendering on Fig. 1, wherein a thickness of representation of the light wave in section 64 is thinner than the thickness of representation of the light wave in section 62. The method also determines that an amplitude of the light wave in section 66 is substantially lower to an amplitude of the light wave in section 64. This is visible in the graphical rendering on Fig. 1, wherein a thickness of representation of the light wave in section 66 is thinner than the thickness of representation of the light wave in section 64.

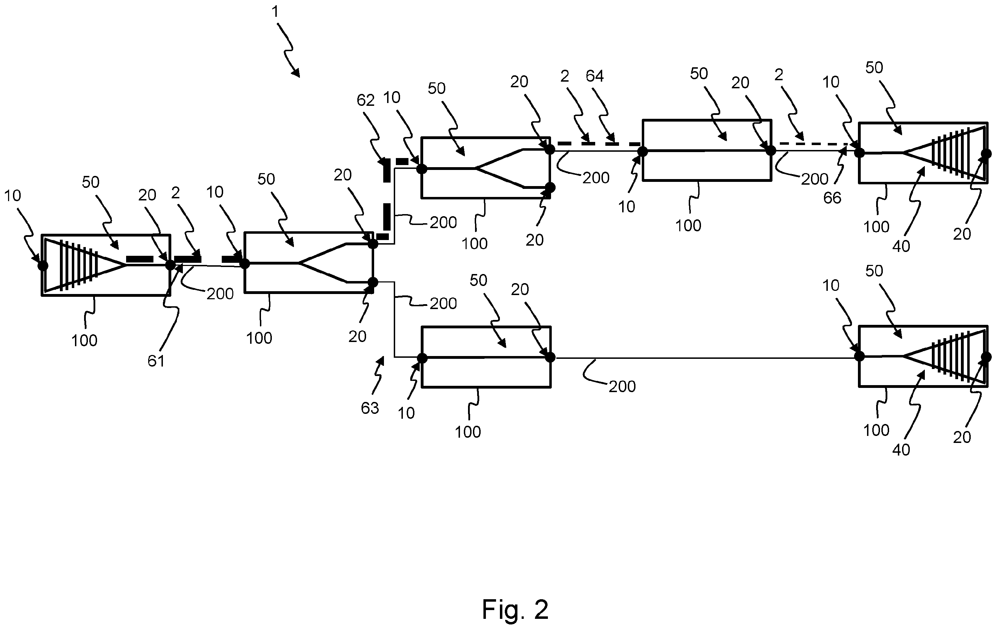

Fig. 2 illustrates an example embodiment of a distribution of a property of a light wave of an optical signal 2, determined by an example embodiment of a method according to the present disclosure. Components having identical references as in Fig. 1 fulfill the same function. The method according to the present disclosure is used for determining a distribution of a property of the light wave in a design 1 of an integrated circuit. The method comprises the steps of receiving a design 1 of an integrated circuit, wherein the design 1 comprises seven devices 100, each of the devices 100 comprising ports 10;20. The devices 100 can be grating couplers, directional couplers, splitters, MMIs, AWGs, waveguides, reflectors, couplers, any other photonic device. The design 1 further comprises a plurality of nets 200, wherein each net 200 couples one of the ports 10 or 20 of one of the devices 100 to one of the ports 10 or 20 of another one of the devices 100. For each of the devices 100, a device scattering matrix 50 is received and indicates between which ports of the device 100 the light wave of the optical signal 2 can propagate within the device 100 and further indicates how much of the property of the light wave is transmitted between ports within the device 100. One of the ports 10 of the design 1 has been selected as a selected port 11. The evolution of at least one property of the light wave of the optical signal 2 from the selected port 11 is determined in function of the device scattering matrices 50 of each of the devices encountered by the light wave propagating from the selected port 11. The light wave starts propagating from the selected port 11 along the section 61. A property of the light wave is for example an amplitude of the light wave, wherein the light wave comprises a wavelength equal to 1.55µm. In section 61, the amplitude corresponds to an initial amplitude value. The light wave further propagates to another device 100 and to section 62. The light wave does not travel to section 63. The method determines that an amplitude of the light wave in section 62 is substantially identical to an amplitude of the light wave in section 61. This is visible in the graphical rendering on Fig. 2, wherein a thickness of representation of the light wave in section 62 is identical to the thickness of representation of the light wave in section 61. After section 62, the light wave keeps propagating through other devices and through sections 64 and 66. The method determines that an amplitude of the light wave in section 64 is substantially lower to an amplitude of the light wave in section 62. This is visible in the graphical rendering on Fig. 2, wherein a thickness of representation of the light wave in section 64 is thinner than the thickness of representation of the light wave in section 62. The method also determines that an amplitude of the light wave in section 66 is substantially lower to an amplitude of the light wave in section 64. This is visible in the graphical rendering on Fig. 2, wherein a thickness of representation of the light wave in section 66 is thinner than the thickness of representation of the light wave in section 64.

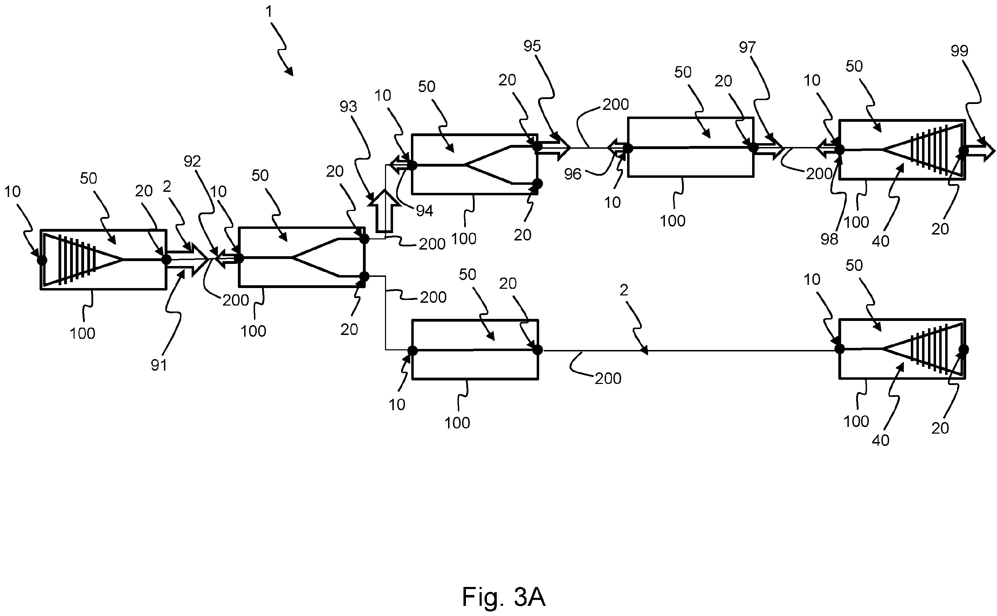

Fig. 3A illustrates an example embodiment of a distribution of a property of a light wave of an optical signal 2, determined by an example embodiment of a method according to the present disclosure. Components having identical references as in Fig. 1 and Fig. 2 fulfill the same function. The method according to the present disclosure is used for determining a distribution of a property of the light wave in a design 1 of an integrated circuit. The method comprises the steps of receiving a design 1 of an integrated circuit, wherein the design 1 comprises seven devices 100, each of the devices 100 comprising ports 10;20. The devices 100 can be grating couplers, directional couplers, splitters, MMIs, AWGs, waveguides, reflectors, couplers, any other photonic device. The design 1 further comprises a plurality of nets 200, wherein each net 200 couples one of the ports 10 or 20 of one of the devices 100 to one of the ports 10 or 20 of another one of the devices 100. For each of the devices 100, a device scattering matrix 50 is received and indicates between which ports of the device 100 the light wave of the optical signal 2 can propagate within the device 100 and further indicates how much of the property of the lightwave is transmitted between ports within the device 100. One of the ports 10 of the design 1 has been selected as a selected port 11. The evolution of at least one property of the light wave of the optical signal 2 from the selected port 11 is determined in function of the device scattering matrices 50 of each of the devices encountered by the light wave propagating from the selected port 11. The light wave starts propagating from the selected port 11 and leaves the first device, a grating coupler, from the port 91. A property of the light wave is for example an amplitude of the light wave, wherein the light wave comprises a wavelength equal to 1.56µm. The amplitude leaving through port 91 corresponds to an initial amplitude value. The light wave further propagates to another device 10, entering through the port 92. The method determines that an amplitude of the light wave leaving the second device through the port 93 is substantially identical to an amplitude of the light wave leaving the first device through port 91. This is visible in the graphical rendering on Fig. 3A, wherein a surface of the arrow indicative of the light wave at port 91 is identical to a surface of the arrow indicative of the light wave at port 93. After port 93, the light wave keeps propagating through other devices 100. The method determines that an amplitude of the light wave leaving through port 95 is substantially lower to an amplitude of the light wave leaving through port 93. This is visible in the graphical rendering on Fig. 3A, wherein a surface of the arrow representation of the light wave leaving through port 95 is smaller than a surface of the arrow representation of the light wave leaving through port 93. The method also determines that an amplitude of the light wave leaving through port 97 is substantially lower to an amplitude of the light wave leaving port 95. This is visible in the graphical rendering on Fig. 3A, wherein a surface of the arrow representation of the light wave leaving through port 97 is smaller than a surface of the arrow representation of the light wave leaving through port 95. The method determines that an amplitude of the light wave leaving the last device through the port 99 is substantially identical to an amplitude of the light wave leaving the previous device through port 97. This is visible in the graphical rendering on Fig. 3A, wherein a surface of the arrow indicative of the light wave at port 91 is identical to a surface of the arrow indicative of the light wave at port 93. The light wave can reflect on the grating coupler 100 comprising the ports 98 and 99. At least a portion of the original light wave will travel back in the design, leaving the grating coupler through port 98 and entering the previous device through port 97, then leaving the previous device through port 96 and entering the neighboring device through port 95, etc. until the reflected light wave leaves the splitter through port 92 and enters the first device through port 91. This is visible in the graphical rendering on Fig. 3A, wherein an orientation of arrows indicative of the reflected light wave is opposite to the orientation of the arrows indicative of the light wave.

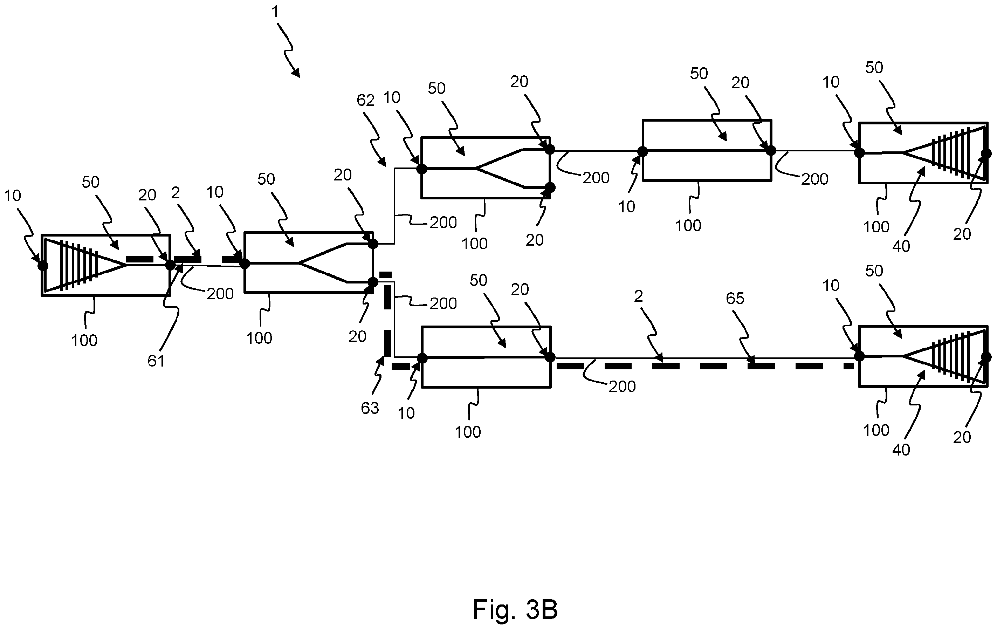

Fig. 3B illustrates an example embodiment of a distribution of a property of a light wave of an optical signal 2, determined by an example embodiment of a method according to the present disclosure. Components having identical references as in Fig. 1 and Fig. 2 fulfill the same function. The method according to the present disclosure is used for determining a distribution of a property of the light wave in a design 1 of an integrated circuit. The method comprises the steps of receiving a design 1 of an integrated circuit, wherein the design 1 comprises seven devices 100, each of the devices 100 comprising ports 10;20. The devices 100 can be grating couplers, directional couplers, splitters, MMIs, AWGs, waveguides, reflectors, couplers, any other photonic device. The design 1 further comprises a plurality of nets 200, wherein each net 200 couples one of the ports 10 or 20 of one of the devices 100 to one of the ports 10 or 20 of another one of the devices 100. For each of the devices 100, a device scattering matrix 50 is received and indicates between which ports of the device 100 the light wave of the optical signal 2 can propagate within the device 100 and further indicates how much of the property of the lightwave is transmitted between ports within the device 100. One of the ports 10 of the design 1 has been selected as a selected port 11. The evolution of at least one property of the light wave of the optical signal 2 from the selected port 11 is determined in function of the device scattering matrices 50 of each of the devices encountered by the light wave propagating from the selected port 11. The light wave starts propagating from the selected port 11 along the section 61. A property of the light wave is for example an amplitude of the light wave, wherein the lightwave comprises a wavelength equal to 1.56µm. In section 61, the amplitude corresponds to an initial amplitude value. The light wave further propagates to another device 100 and to section 63. The light wave does not travel to section 62. The method determines that an amplitude of the light wave in section 63 is substantially identical to an amplitude of the light wave in section 61. This is visible in the graphical rendering on Fig. 3B, wherein a thickness of representation of the light wave in section 63 is identical to the thickness of representation of the light wave in section 61. After section 63, the light wave keeps propagating through other devices and through section 65. The method determines that an amplitude of the light wave in section 65 substantially identical to an amplitude of the light wave in section 63. This is visible in the graphical rendering on Fig. 3B, wherein a thickness of representation of the light wave in section 65 is identical to the thickness of representation of the light wave in section 63.

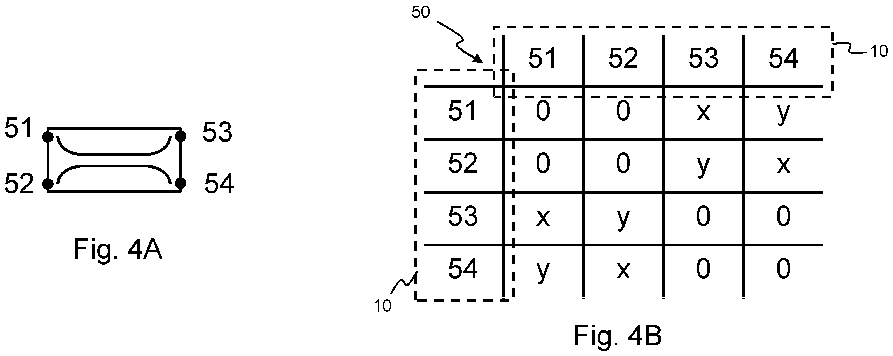

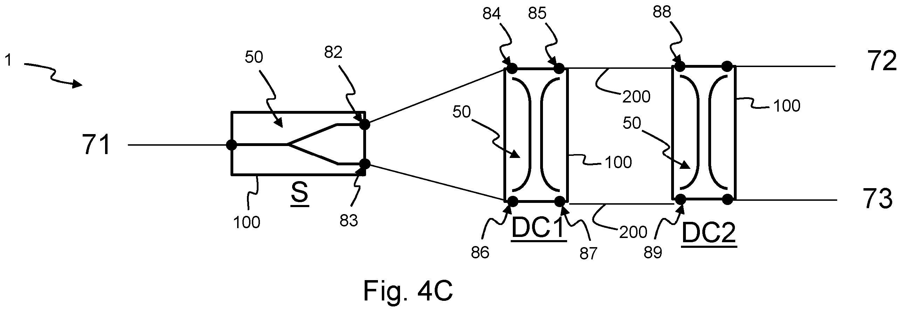

Fig. 4A schematically illustrates an example embodiment of a directional coupler. Fig. 4B schematically illustrates an example embodiment of a device scattering matrix 50 of the directional coupler of Fig. 4A, indicating how much light x;y goes from one port 10 labelled 51;52;53;54 to another port 10 labelled 51;52;53;54 for a particular wavelength, wherein ports 10 labelled 51;52 are input ports and wherein ports 10 labelled 53;54 are output ports to the directional coupler of Fig. 4A. Fig. 4C schematically illustrates an example embodiment of a design 1 comprising a splitter 100 and two directional couplers 100. Each device is characterized by one or more ports 10 labelled 71;82;83;84;85;86;87;88;89;72;73 and a device scattering matrix 50, wherein the port 10 labelled 71 is an input port of the splitter S, the ports 10 labelled 82;83 are output ports of the splitter, the ports 10 labelled 84;85 are input ports of the first directional coupler DC1, the ports 10 labelled 86;87 are output ports of the first directional coupler, the ports 10 labelled 88 and 72 are input ports of the second directional coupler DC2, the ports 10 labelled 89;73 are output ports of the second directional coupler. The devices are connected via nets 200. Fig. 4D schematically illustrates an example embodiment of a design scattering matrix 40 for the design of Fig. 4C, indicating whether light can propagate from one port 10 labelled 71;82;83;84;85;86;87;88;89;72;73 of the design 1 to another port 10 labelled 71;82;83;84;85;86;87;88;89;72;73 of the design 1 and how much of the light wave is transmitted between two ports 10 labelled 71;82;83;84;85;86;87;88;89;72;73 as indicated numerically by a, b, c, x, y, z, D, E, F, G, H, I, J, K, L, M, N, O, P, Q, R, S, etc. wherein the design scattering matrix 40 is full. The design scattering matrix 40 comprises a scattering matrix 41 for the outermost ports 10 labelled 71;72;73 of the design of Fig. 4C. In the context of the present disclosure, a design scattering matrix comprises rows corresponding to all the input ports and all the output ports of all the devices of the design, and further comprises columns corresponding to all the input ports and all the output ports of all the devices of the design. In the example depicted on Fig. 4D, instead of only considering the outermost ports 71;72;73 of the design, and only relying on a 3x3 matrix, the design scattering matrix 50 of Fig. 4D considers all the ports 10 labelled 82;83;84;85;86;87;88;89 of all the devices of the design, and the design scattering matrix is a 11x11 matrix.

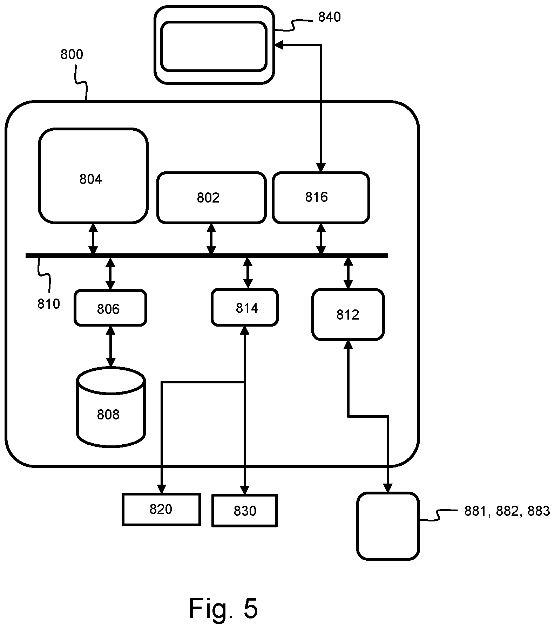

Fig. 5 shows a suitable computing system 800 enabling to implement embodiments of the system. Computing system 800 may in general be formed as a suitable general-purpose computer and comprise a bus 810, a processor 802, a local memory 804, one or more optional input interfaces 814, one or more optional output interfaces 816, a communication interface 812, a storage element interface 806, and one or more storage elements 808. Bus 810 may comprise one or more conductors that permit communication among the components of the computing system 800. Processor 802 may include any type of conventional processor or microprocessor that interprets and executes programming instructions. Local memory 804 may include a random-access memory (RAM) or another type of dynamic storage device that stores information and instructions for execution by processor 802 and/or a read only memory (ROM) or another type of static storage device that stores static information and instructions for use by processor 802. Input interface 814 may comprise one or more conventional mechanisms that permit an operator or user to input information to the computing device 800, such as a keyboard 820, a mouse 830, a pen, voice recognition and/or biometric mechanisms, a camera, etc. Output interface 816 may comprise one or more conventional mechanisms that output information to the operator or user, such as a display 840, etc. Communication interface 812 may comprise any transceiver-like mechanism such as for example one or more Ethernet interfaces that enables computing system 800 to communicate with other devices and/or systems, for example with other computing devices 881, 882, 883. The communication interface 812 of computing system 800 may be connected to such another computing system by means of a local area network (LAN) or a wide area network (WAN) such as for example the internet. Storage element interface 806 may comprise a storage interface such as for example a Serial Advanced Technology Attachment (SATA) interface or a Small Computer System Interface (SCSI) for connecting bus 810 to one or more storage elements 808, such as one or more local disks, for example SATA disk drives, and control the reading and writing of data to and/or from these storage elements 808. Although the storage element(s) 808 above is/are described as a local disk, in general any other suitable computer-readable media such as a removable magnetic disk, optical storage media such as a CD or DVD, -ROM disk, solid state drives, flash memory cards, ... could be used. It is noticed that the entire computer-implemented method according to the present invention can be executed centralized, e.g. on a server in a management center or in a cloud system, or it can be partially executed on a remote electronic device, e.g. worn by the user, and partially on a central server. Computing system 800 could thus correspond to the system available centrally or the processing system available in the electronic device.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the scope of the claims are therefore intended to be embraced therein.

It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A computer-implemented method for determining a distribution of one or more properties of a light wave of an optical signal (2) propagating in a design (1) of an integrated circuit, the method comprising the steps of:
- receiving a design (1) of an integrated circuit comprising:
∘ a plurality of devices (100), each of the devices (100) comprising ports (10); and
∘ one or more nets (200), each net (200) coupling one of the ports (10) of one of the devices (100) to one of the ports (10) of another one of the devices (100);
- for each of the devices (100), receiving a device scattering matrix (50);
- receiving a design scattering matrix (40) for the design (1), wherein the design scattering matrix (40) comprises:
∘ information comprised in the device scattering matrices (50); and
∘ information indicating one or more properties of the light wave of the optical signal (2) propagating between any pair of ports (10) of the ports (10) of the design (1), wherein any one of the ports (10) of the pair of ports (10) can be coupled to another one of the ports (10) of the design (1) through one of the nets (200);
- selecting one of the ports (10) of one of the devices (100) through which the optical signal (2) enters the design (1); and
- determining, in function of the nets (200) and in function of the design scattering matrix (40), a distribution of one or more properties of the light wave of the optical signal (2) for each of the ports (10) along which the optical signal (2) propagates starting from the selected port (10).

2. The method according to claim 1, wherein the one or more properties comprise one or more of the following:
- an amplitude of the light wave of the optical signal;
- an intensity of the light wave of the optical signal;
- a phase of the light wave of the optical signal;
- one or more losses for the light wave of the optical signal;
- a dispersion of the light wave of the optical signal.

3. The method according to any of the preceding claims, wherein the design scattering matrix (40) for the design (1) relates a property of the light wave of the optical signal (2) entering the design (1) through one of the ports (10) of one of the devices (100) to a property of the light wave of the optical signal (2) leaving the design (1) through one of the ports (10) of one of the devices (100).

4. The method according to any of the preceding claims, wherein each device scattering matrix (50) relates a property of the light wave of the optical signal (2) entering the device (100) through one of the device ports (10) to a property of the light wave of the optical signal (2) leaving the device (100) through one of the device ports (10).

5. The method according to any of the preceding claims, wherein the design scattering matrix (40) comprises information indicative for how much of the optical signal (2) propagates from one of the ports (10) to another one of the ports (10) per wavelength or frequency comprised in the optical signal (2).

6. The method according to any of the preceding claims, wherein each device scattering matrix (50) of each device (100) comprises information indicative for how much of the optical signal (2) propagates from one of the device ports (10) of the device (100) to another one of the device ports (10) of the device (100) per wavelength or frequency comprised in the optical signal (2).

7. The method according to any of the preceding claims, wherein the design scattering matrix (40) comprises information indicative for how much of the optical signal (2) propagates from one of the ports (10) to another one of the ports (10) for each optical mode comprised in the optical signal (2).

8. The method according to any of the preceding claims, wherein each device scattering matrix (50) of each device (100) comprises information indicative for how much of the optical signal (2) propagates from one of the device ports (10) of the device (100) to another one of the device ports (10) of the device (100) for each optical mode comprised in the optical signal (2).

9. The method according to any of the preceding claims, wherein the method further comprises the steps of:
- determining a device scattering matrix (50) for each device of a plurality of available devices comprising the devices (100) of the design (1) of the integrated circuit; and
- storing the device scattering matrices (50) of the available devices in a database; and wherein, upon receipt of the design (1) of the integrated circuit, the step of receiving a device scattering matrix (50) for each of the devices (100) of the design (1) of the integrated circuit corresponds to retrieving the device scattering matrices (50) of the devices (100) of the design (1) of the integrated circuit from the database.

10. The method according to any of the claims 1 to 8, wherein, upon receipt of the design (1) of the integrated circuit, the step of receiving a device scattering matrix (50) for each of the devices (100) of the design (1) of the integrated circuit corresponds to determining a device scattering matrix (50) for each of the devices (100) of the design (1) of the integrated circuit.

11. The method according to any of the preceding claims, wherein the method further comprises the steps of:
- generating a representation of the design (1) of the integrated circuit incorporating the one or more optical paths (60) and the distribution of one or more properties of the light wave of the optical signal (2) for each of the nets (200) along each of the optical paths (60) and for each of the ports (10) in the design (1); and
- displaying the representation of the design (1) of the integrated circuit in a user client.

12. A system for determining a distribution of one or more properties of a light wave of an optical signal (2) propagating in a design (1) of an integrated circuit, the method comprising the steps of:
- receiving a design (1) of an integrated circuit comprising:
∘ a plurality of devices (100), each of the devices (100) comprising ports (10); and
∘ one or more nets (200), each net (200) coupling one of the ports (10) of one of the devices (100) to one of the ports (10) of another one of the devices (100);
- for each of the devices (100), receiving a device scattering matrix (50);
- receiving a design scattering matrix (40) for the design (1), wherein the design scattering matrix (40) comprises:
∘ information comprised in the device scattering matrices (50); and
∘ information indicating one or more properties of the light wave of the optical signal (2) propagating between any pair of ports (10) of the ports (10) of the design (1), wherein any one of the ports (10) of the pair of ports (10) can be coupled to another one of the ports (10) of the design (1) through one of the nets (200);
- selecting one of the ports (10) of one of the devices (100) through which the optical signal (2) enters the design (1); and
- determining, in function of the nets (200) and in function of the design scattering matrix (40), a distribution of one or more properties of the light wave of the optical signal (2) for each of the ports (10) along which the optical signal (2) propagates starting from the selected port (10).

13. A computer program product comprising computer-executable instructions for causing a system to perform at least the following:
- receiving a design (1) of an integrated circuit comprising:
∘ a plurality of devices (100), each of the devices (100) comprising ports (10); and
∘ one or more nets (200), each net (200) coupling one of the ports (10) of one of the devices (100) to one of the ports (10) of another one of the devices (100);
- for each of the devices (100), receiving a device scattering matrix (50);
- receiving a design scattering matrix (40) for the design (1), wherein the design scattering matrix (40) comprises:
∘ information comprised in the device scattering matrices (50); and
∘ information indicating one or more properties of the light wave of the optical signal (2) propagating between any pair of ports (10) of the ports (10) of the design (1), wherein any one of the ports (10) of the pair of ports (10) can be coupled to another one of the ports (10) of the design (1) through one of the nets (200);
- selecting one of the ports (10) of one of the devices (100) through which the optical signal (2) enters the design (1); and
- determining, in function of the nets (200) and in function of the design scattering matrix (40), a distribution of one or more properties of the light wave of the optical signal (2) for each of the ports (10) along which the optical signal (2) propagates starting from the selected port (10).

14. A computer readable storage medium comprising computer-executable instructions for performing the following steps when the program is run on a computer:
- receiving a design (1) of an integrated circuit comprising:
∘ a plurality of devices (100), each of the devices (100) comprising ports (10); and
∘ one or more nets (200), each net (200) coupling one of the ports (10) of one of the devices (100) to one of the ports (10) of another one of the devices (100);
- for each of the devices (100), receiving a device scattering matrix (50);
- receiving a design scattering matrix (40) for the design (1), wherein the design scattering matrix (40) comprises:
∘ information comprised in the device scattering matrices (50); and
∘ information indicating one or more properties of the light wave of the optical signal (2) propagating between any pair of ports (10) of the ports (10) of the design (1), wherein any one of the ports (10) of the pair of ports (10) can be coupled to another one of the ports (10) of the design (1) through one of the nets (200);
- selecting one of the ports (10) of one of the devices (100) through which the optical signal (2) enters the design (1); and
- determining, in function of the nets (200) and in function of the design scattering matrix (40), a distribution of one or more properties of the light wave of the optical signal (2) for each of the ports (10) along which the optical signal (2) propagates starting from the selected port (10).
